Europäisches Patentamt

European Patent Office

Office européen des brevets

(11) Numéro de publication: **0 272 178 B1**

(12) **FASCICULE DE BREVET EUROPEEN**

(45) Date de publication de fascicule du brevet:
11.09.91

(51) Int. Cl.5: **H01J 1/30**, H01J 37/073, H01J 3/02

(21) Numéro de dépôt: **87402646.1**

(22) Date de dépôt: **24.11.87**

(54) Source d'électrons polarisés de spin, utilisant une cathode émissive à micropointes, application en physique des interactions électrons-matière ou électrons-particules,physique des plasmas, microscopie électronique.

(30) Priorité: **27.11.86 FR 8616553**

(43) Date de publication de la demande:
**22.06.88 Bulletin 88/25**

(45) Mention de la délivrance du brevet:
**11.09.91 Bulletin 91/37**

(84) Etats contractants désignés:
**DE GB IT NL**

(56) Documents cités:
**EP-A- 0 172 089**

**APPLIED PHYSICS, vol. 14, no. 2, octobre 1977, pages 149-153, Springer-Verlag; G. BAUM et al.: "Field emission of monoenergetic spin-polarized electrons"**

(73) Titulaire: **COMMISSARIAT A L'ENERGIE ATOMIQUE Etablissement de Caractère Scientifique Technique et Industriel
31/33, rue de la Fédération
F-75015 Paris(FR)**

(72) Inventeur: **Baptist, Robert
Les Chaberts
F-38560 Jarrie(FR)**
Inventeur: **Brenac, Ariel
1, rue du Docteur Calmette
F-38130 Echirolles(FR)**
Inventeur: **Chauvet, Gérard
8, rue Charles Lory
F-38000 Grenoble(FR)**
Inventeur: **Meyer, Robert
Chemin de la Limite St Nazaire les Eymes
F-38330 Saint Ismier(FR)**
Inventeur: **Muller, Francis
160, Avenue Victor Hugo
F-38170 Seyssinet(FR)**

(74) Mandataire: **Mongrédien, André et al
c/o BREVATOME 25, rue de Ponthieu
F-75008 Paris(FR)**

Rank Xerox (UK) Business Services

**Description**

La présente invention concerne une source d'électrons polarisés de spin, utilisant une cathode émissive à micropointes. Elle s'applique notamment à la physique des interactions électrons-matière et en particulier à la physique des surfaces, à la physique des interactions électrons-particules (atomes, ions, particules sub-atomiques), à la physique des plasmas et à la microscopie électronique.

On connaît déjà des sources d'électrons polarisés de spin, utilisant une couche d'arséniure de gallium recouverte d'une couche de césium. Un faisceau d'électrons polarisés de spin est obtenu par éclairement de la surface de la couche de césium par une lumière issue d'un laser, ayant une énergie bien définie, cette lumière étant en outre polarisée circulairement.

De telles sources sont connues par :
- l'article de S. ALVARADO et al., dans le livre intitulé Photoemission and the electronic properties of surfaces, publié sous la direction de B. FEUERBACHER et al., John Wiley and Sons, 1978,
- l'article de H.J. DROUIN et al., Courrier du CNRS, supplément de la Physique, n°59, 1985 p.86,
- l'article de D.T. PIERCE et al., Rev. of Sci. Instr. 51(4), 1980, p.478,
- l'article de G. LAMPEL, Phys. Rev. Lett, 20, 1968, p.491,
- l'article de H.C. SIEGMANN et al., Phys. Rev. Lett., vol.46, n°6, 1981, p.452.

Ces sources présentent les inconvénients suivants : elles nécessitent un matériel compliqué et encombrant (alimentation électrique, laser...) ; la réalisation du dépôt de césium est une opération délicate qui doit être effectuée sous ultravide (au moins $10^{-8}$ Pa) ; le dépôt de césium doit être renouvelé fréquemment afin de conserver les caractéristiques physiques du faisceau d'électrons (taux de polarisation de l'ordre de 50%, courant électronique de quelques dizaines de microampères pour une dispersion en énergie de l'ordre de 0,3 eV) ; l'intensité du faisceau d'électrons obtenu est faible ; enfin, les électrons ont des spins parallèles (ou anti-parallèles) à leur trajectoire au moment où ils quittent la couche de césium.

On connaît également d'autres sources d'électrons polarisés de spin, utilisant une pointe macroscopique de tungstène recouverte d'une fine couche (de l'ordre de 50 nanomètres d'épaisseur) d'une substance isolante et ferromagnétique à très basse température telle que EuS. En portant la pointe à une tension de plusieurs kilovolts par rapport à une anode et en soumettant la pointe à un champ magnétique parallèle à cette pointe, des électrons sont extraits de cette dernière par effet de champ et acquièrent, en passant à travers la couche de EuS, une polarisation de spin.

Ces autres sources sont notamment connues par :
- l'article E. KISKER et al., Phys. Rev. Lett., vol.36 n°16, 1976, p.982,
- l'article de G. BAUM et al., Applied Physics, 14, 1977, p.149.

De telles sources présentent également des inconvénients : elles nécessitent des tensions électriques de l'ordre du kilovolt et donc des installations encombrantes ; les courants électroniques obtenus avec ces sources ont de très faibles intensités, de l'ordre de $10^{-8}$ A (avec toutefois une résolution énergétique de l'ordre de 100 meV et un taux de polarisation pouvant atteindre 85% pour une température de 9K).

La présente invention a pour but de remédier aux inconvénients précédents en proposant une source d'électrons polarisés de spin, réalisable de façon assez simple, durable, peu encombrante, peu pesante (ce qui permet de la placer à bord d'un satellite artificiel), qui permet d'obtenir des faisceaux intenses d'électrons (ce qui est intéressant pour certaines applications en physique des plasmas), tout en conservant une résolution énergétique et un taux de polarisation corrects, et qui, dans certaines réalisations, permet d'obtenir des électrons dont les spins sont perpendiculaires à la trajectoire de ces électrons (étant entendu que d'autres réalisations permettent d'obtenir des électrons dont les spins sont parallèles à la trajectoire de ces électrons).

A cet effet, la présente invention utilise une cathode émissive à micropointes d'un type particulier.

Des cathodes émissives à micropointes sont déjà connues par US-A-3755704, US-A-3921022, FR-A-2443085 et la demande de brevet français n°8411986 du 27 juillet 1984 (ou la demande aux USA n°758737 du 25 juillet 1985) par exemple.

De façon précise, la présente invention a pour objet une source d'électrons polarisés de spin, caractérisée en ce qu'elle comprend au moins une première électrode dont une face est pourvue d'une pluralité de micropointes qui sont faites d'un matériau émetteur d'électrons et dont les bases se trouvent sur ladite face, et au moins une seconde électrode, cette seconde électrode étant électriquement isolée de la première électrode, disposée en regard de ladite face et percée de trous situés respectivement en regard desdites bases, le sommet de chaque micropointe étant situé au niveau du trou qui lui correspond, de sorte que des électrons sont émis par les micropointes lorsque celles-ci sont dans le vide et que la seconde électrode est polarisée positivement par rapport à la première électrode, et en ce qu'au moins une portion de chaque micropointe, incluant le sommet de celle-ci, est ferromagnétique, de façon que les électrons émis soient polarisés de spin suivant une direction donnée, lorsque chaque portion est soumise à un champ magnétique parallèle à ladite direction donnée.

Avec une densité de 10000 micropointes par millimètre carré on peut ainsi obtenir un courant électronique de l'ordre de 100 microampères pour une tension de l'ordre de 80 volts entre la première et la seconde électrodes. La résolution énergétique peut être de l'ordre de 0,3 eV à 1,3 eV.

Selon une réalisation particulière de l'invention, chaque portion est faite ou recouverte d'un matériau ferromagnétique à température ambiante (c'est-à-dire de l'ordre de 20° C).

Ledit matériau ferromagnétique est par exemple le fer, le nickel ou un alliage contenant du fer et du nickel.

On s'affranchit ainsi avantageusement de dispositifs encombrants de réfrigération, du genre de ceux qui sont nécessaires pour les sources à pointe de tungstène recouvert de EuS.

Dans un mode de réalisation particulier de la source objet de l'invention, correspondant à la réalisation particulière précédente, les micropointes étant orientées suivant un même axe, ladite source comprend en outre des moyens pour soumettre chaque portion à un champ magnétique parallèle à cet axe.

La source objet de l'invention peut comprendre plusieurs exemplaires parallèles et de forme allongée de ladite première électrode et plusieurs exemplaires parallèles et de forme allongée de ladite seconde électrode, les premières électrodes faisant un angle avec les secondes électrodes, ce qui définit des zones de croisement des premières et secondes électrodes, les micropointes et les trous étant situés dans ces zones de croisement.

En polarisant convenablement les premières et secondes électrodes, on peut alors sélectionner une ou plusieurs zones de croisement déterminées en vue d'émettre un faisceau d'électrons.

Dans ce cas, les micropointes étant orientées suivant un même axe, ladite source peut comprendre en outre des moyens pour soumettre individuellement chaque zone de croisement à un champ magnétique parallèle à cet axe.

Dans un mode de réalisation particulier de la source objet de l'invention, correspondant également à la réalisation particulière mentionnée plus haut, les micropointes étant orientées suivant un même axe, ladite seconde électrode comporte une couche plane perpendiculaire audit même axe et faite d'un matériau ferromagnétique à température ambiante.

Dans une réalisation particulière de l'invention, l'épaisseur de la couche plane est au moins égale à la hauteur de ladite portion de micropointe, comptée parallèlement audit axe et chaque portion de micropointe est comprise dans le trou qui lui correspond dans ladite couche plane.

La source peut comprendre en outre des moyens pour soumettre chaque portion de micropointe à un champ magnétique perpendiculaire à ladite couche plane ou des moyens pour soumettre chaque portion de micropointe à un champ magnétique parallèle à ladite couche plane et canalisé par cette couche plane. Le champ peut être constant ou peut être variable, parallèlement à la couche plane, en direction et/ou en sens et/ou en intensité. On peut par exemple réaliser un champ tournant parallèlement à ladite couche plane, ce qui permet d'obtenir des électrons polarisés de spin, dont le spin tourne autour de la direction de propagation des électrons.

Dans ce dernier cas (champ parallèle à la couche plane), on peut obtenir des électrons polarisés de spin, dont les spins sont parallèles à la couche plane et donc perpendiculaires à la trajectoire des électrons (qui est perpendiculaire à cette couche). On obtient ainsi directement cette polarisation particulière des spins, sans avoir à utiliser des dispositifs tels que des analyseurs électrostatiques, en vue de courber la trajectoire des électrons pour obtenir une telle polarisation, ce qui était notamment le cas dans les sources d'électrons polarisés de spin utilisant l'arséniure de gallium.

La présente invention sera mieux comprise à la lecture de la description qui suit d'exemples de réalisation donnés à titre purement indicatif et nullement limitatif, en référence aux dessins annexés sur lesquels :
- la figure 1 est une vue schématique d'un mode de réalisation particulier de la source objet de l'invention,
- la figure 2 est une vue de détail de la source représentée sur la figure 1,
- la figure 3 est une variante de réalisation de la source représentée sur la figure 1,
- la figure 4 est une vue schématique d'un autre mode de réalisation particulier de la source objet de l'invention,
- la figure 5 est une vue schématique d'un autre mode de réalisation particulier de la source objet de l'invention,
- la figure 6 est une vue schématique d'un autre mode de réalisation particulier de la source objet de l'invention, et
- la figure 7 est une variante de réalisation de la source représentée sur la figure 6.

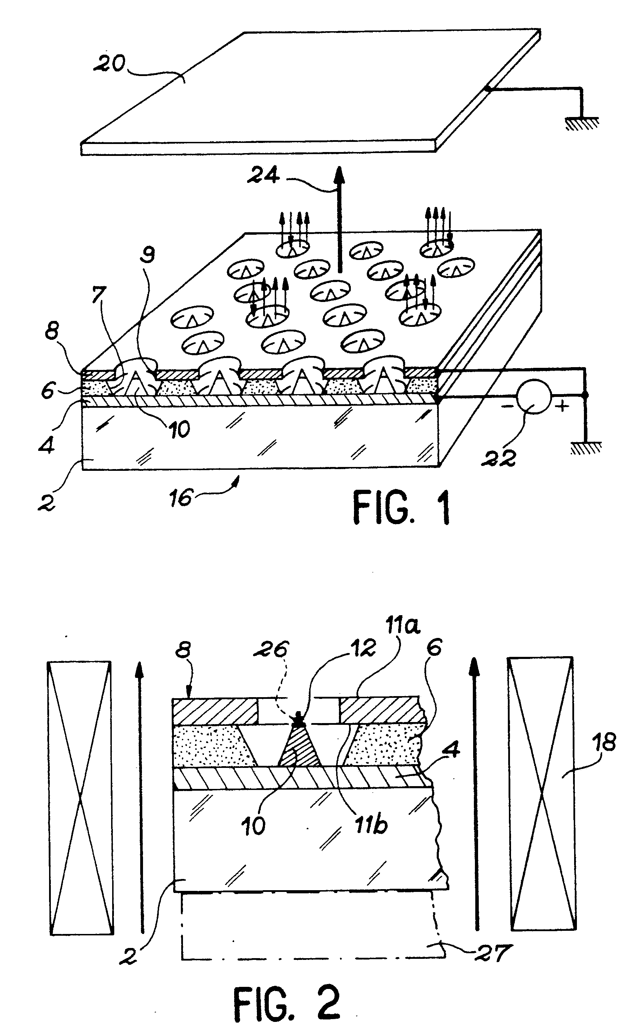

Sur la figure 1, on a représenté schématiquement un mode de réalisation particulier de la source d'électrons polarisés de spin objet de l'invention, comprenant un substrat en verre 2 sur lequel est déposée une couche plane électriquement conductrice 4 recouverte d'une couche plane électriquement isolante 6, elle-même recouverte d'une couche plane électriquement conductrice 8 appelée grille. Les couches 6 et 8 sont percées de trous 7, 9 régulièrement espacés les uns des autres, ce qui fait apparaître la couche 4. Dans chacun des trous, est disposée une micropointe sensiblement conique 10 électriquement conductrice, qui s'élève à partir de la couche 4 en direction de la couche 8 et dont le sommet se situe entre le niveau de la surface 11a de la couche 8 et le niveau de la base 11b de cette couche 8.

Les micropointes 10 peuvent être faites d'un matériau ferromagnétique à la température ambiante. En variante, une portion 12 de chaque micropointe (figure 2), ladite portion incluant le sommet de cette micropointe, est faite d'un matériau ferromagnétique à la température ambiante, tandis que le reste de la micropointe est fait d'un matériau électriquement conducteur.

La hauteur de ladite portion 12 est ajustée au moment de l'élaboration des micropointes.

Cet ajustement peut être effectué de manière à réaliser des portions 12 de volume suffisamment faible, pour aboutir, sous champ magnétique, à des portions 12 ne comportant qu'un seul monodomaine magnétique (domaine de WEISS).

A titre purement indicatif et nullement limitatif, la couche 4 est en $In_2O_3$ ou en Si fortement dopé N ou P et a une épaisseur de l'ordre d 150 nanomètres ; la couche 6 est en $SiO_2$ et a une épaisseur de l'ordre de 1 micromètre ; la couche 8 est en molybdène ou en niobium et a une épaisseur de l'ordre de 0,4 micromètre ; les trous 9 de la couche 8 ont un diamètre de l'ordre de 1,5 micromètre ; les micropointes 10 ont une hauteur de l'ordre de 1,4 micromètre et une base de diamètre de l'ordre de 1 micromètre ; ces micropointes 10 sont en molybdène, excepté dans leur portion ferromagnétique 12 qui est en fer et à une hauteur de l'ordre de 20 à 30 nanomètres.

La cathode émettrice à micropointes 16 ainsi obtenue est placée dans un champ magnétique perpendiculaire au plan de la couche 8 et par exemple obtenu au moyen d'un bobine magnétique 18 (figure 2) dans laquelle on dispose la cathode émissive 16 de telle manière que la couche 8 soit perpendiculaire à l'axe de la bobine (qui est ainsi parallèle aux axes des micropointes).

On souhaite par exemple étudier l'interaction des électrons que la cathode émissive 16 est capable d'émettre sous certaines conditions de polarisation, avec un échantillon 20. A cet effet, l'ensemble comportant la bobine, la cathode et l'échantillon étant mis sous vide, on porte la couche 4 et donc les micropointes 10 à un potentiel négatif par rapport à la couche 8 qui peut être mise à la masse, au moyen d'une source appropriée 22, l'échantillon 20 pouvant être mis à la masse ou porté à un potentiel positif par rapport à la couche 8 au moyen d'une source non représentée.

En appliquant par exemple une tension de l'ordre de 80 volts entre les couches 4 et 8, des électrons sont émis par les micropointes 10 suivant une direction 24 perpendiculaire à la couche 8. Du fait de la présence des portions ferromagnétique 12, les électrons sont polarisés de spin et ont ainsi, pour la plupart, des spins parallèles à la direction 24 et de même sens que le champ magnétique créé (les spins étant orientés de la couche 8 vers l'échantillon 20 dans le cas particulier des figures 1 et 2).

Au lieu de réaliser les micropointes 10 avec une portion ferromagnétique 12, on pourrait réaliser ces micropointes en un métal non ferromagnétique et munir ces micropointes d'une couche 26 d'un métal ferromagnétique à température ambiante recouvrant au moins en partie, chaque micropointe à partir du sommet de celle-ci.

Le dépôt des couches 26 est par exemple effectué par évaporation sous vide, à travers un masque non représenté, placé contre la couche 8 et pourvu d'ouvertures coaxiales aux micropointes et de diamètre au plus égal au diamètre des trous de la couche 8.

Pour créer le champ magnétique, on pourrait également envisager de réaliser la couche 8 en un matériau ferromagnétique apte à constituer un aimant permanent, après aimantation dans un champ magnétique perpendiculaire à la couche 8, le matériau étant par exemple un alliage samarium-cobalt.

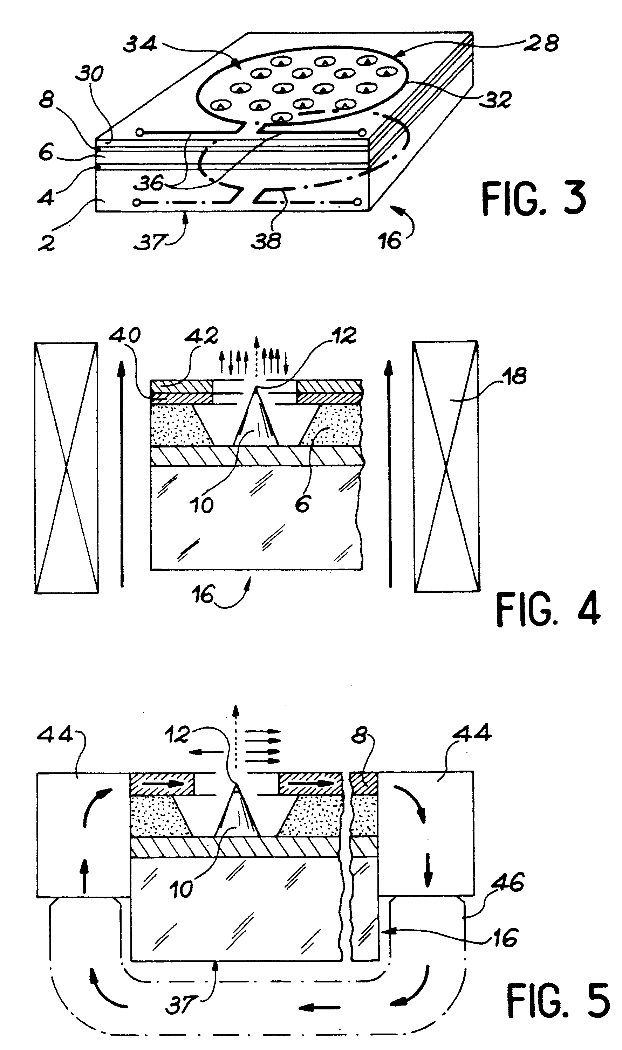

Sur la figure 3 on a représenté schématiquement une source conforme à l'invention, qui diffère simplement de la source représentée sur les figures 1 et 2 par le fait que l'on a intégré à la cathode émissive 16 des moyens 28 permettant de créer un champ magnétique perpendiculaire à la couche conductrice 8. Celle-ci est recouverte d'une couche électriquement isolante 30 par exemple en silice, ayant par exemple une épaisseur de l'ordre de 1 micromètre et percée de trous coaxiaux aux micropointes 10 et de diamètre sensiblement égal à celui des trous 9 de la couche 8. Une électrode 32 est formée sur la couche 30 et entoure l'ensemble des trous formés dans cette couche 30.

L'électrode 32 se présente par exemple sous la forme d'une couche mince et étroite d'un métal tel que l'aluminium, qui est déposée à la surface de la couche 30 et qui épouse sensiblement la forme d'un oméga majuscule à l'intérieur de la boucle duquel se trouve l'ensemble des trous réalisés dans la couche 30 et dont les extrémités libres 36 servent d'amenées de courant, de façon à créer, grâce à la boucle du oméga qui forme une spire, un champ magnétique perpendiculaire au plan des couches 8 et 30.

On peut également déposer sur la face libre 37 de la couche de verre 2, un autre conducteur 38 par exemple en aluminium, ayant la même forme et les mêmes dimensions que le conducteur 32 et situé à l'aplomb de ce dernier, de sorte qu'en faisant passer des courants de sens appropriés dans les conducteurs 32 et 38, on obtient un champ magnétique plus intense qu'en utilisant seulement le conducteur 32.

Sur la figure 4, on a représenté schématiquement un autre mode de réalisation particulier de la source objet de l'invention. Ce mode de réalisation diffère essentiellement du mode de réalisation représenté sur les figures 1 et 2 par le fait que la couche conductrice 8 non ferromagnétique est remplacée par une couche 40 conductrice et non ferromagnétique, par exemple en molybdène et d'épaisseur 100 nanomètres, cette couche 40 étant déposée sur la couche isolante 6 et surmontée d'une autre couche 42 conductrice et ferromagnétique à température ambiante, par exemple en fer ou en alliage cobalt-chrome et d'épaisseur 100 nanomètres. Bien entendu, les couches 40 et 42 sont percées de trous qui les traversent toutes deux, qui ont le même diamètre que les trous 14 et qui sont coaxiaux aux micropointes 10, dont les sommets affleurent à la surface de la couche 42.

On adjoint à la cathode émissive 16 représentée sur la figure 4, des moyens permettant de créer un champ magnétique perpendiculaire à la couche 42, par exemple une bobine magnétique 18 entourant la cathode émissive 16 comme on l'a expliqué en référence à la figure 2, de sorte que l'on peut aimanter la couche 42 perpendiculairement à son plan, ce qui induit une aimantation des micropointes 10 (comportant toujours les portions ferromagnétiques 12) perpendiculairement au plan des couches 40 et 42. En fonctionnement sous vide, on obtient donc un faisceau d'électrons perpendiculaires au plan de la couche 40, les spins des électrons étant en majeure partie perpendiculaires à ce plan et orientés suivant le sens du champ magnétique créé.

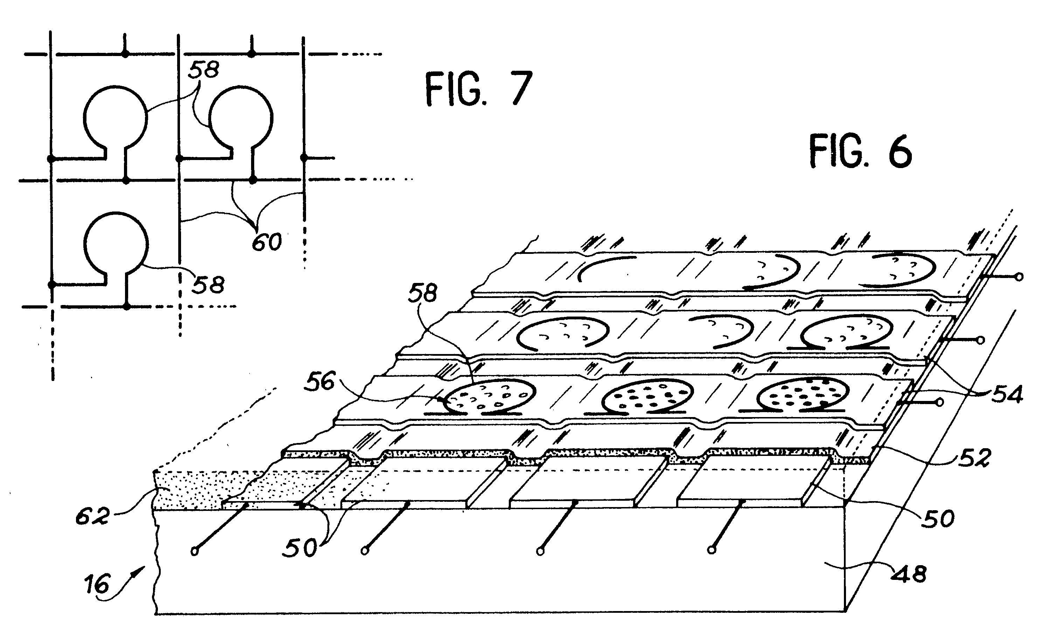

Sur la figure 5, on a représenté schématiquement un mode de réalisation avantageux de la source objet de l'invention, qui diffère essentiellement du mode de réalisation représenté sur les figures 1 et 2 par le fait que la couche 8 est conductrice et ferromagnétique à température ambiante. Il s'agit par exemple d'une couche de fer de 0,4 micromètre d'épaisseur. Deux pattes 44 conductrices et ferromagnétiques par exemple en fer, sont situées contre deux faces latérales opposées de la cathode émissive 16. Ces pattes 44 sont en contact avec la couche ferromagnétique 8 et lui sont par exemple soudées. Les pattes 44 ne dépassent pas de la surface de la couche 8 et ont des dimensions prévues pour ne pas dépasser des côtés de la cathode émissive 16 contre lesquels elles se trouvent.

Un petit aimant permanent 46 en U est situé sous la face libre 37 de la couche de verre de la cathode émissive 16 et les pôles de cet aimant sont respectivement raccordés aux deux pattes 44. L'aimant 46, les pattes 44 et la couche ferromagnétique forment ainsi un circuit magnétique. Les dimensions respectives des pattes 44 et de l'aimant 46 sont choisies pour que la totalité des lignes de force du champ magnétique soit canalisées par la couche ferromagnétique 8 et ne passent pas au-dessus de la surface de cette couche 8.

Dans cette dernière, l'aimantation est parallèle au plan de la couche ferromagnétique 8. Bien entendu, chaque micropointe 10 comprend encore ladite portion ferromagnétique 12. En fonctionnement sous vide, les électrons sont émis perpendiculairement au plan de la couche 8 mais les spins des électrons sont à présent en majeure partie parallèles au plan de cette couche 8 du fait de la direction de l'aimantation de cette couche 8 et orientés suivant le sens du champ magnétique présent dans la couche 8.

Bien entendu, la réalisation décrite en référence à la figure 5 est adaptable à la cathode émissive 16 décrite en référence à la figure 4, en formant le circuit magnétique avec la couche 42, les pattes 44 et l'aimant 46, comme on l'a expliqué à propos de la couche 8, des pattes 44 et de l'aimant 46 dans la description de la figure 5.

A titre purement indicatif et nullement limitatif, la couche 8 (figure 5) est en vue de dessus, un carré de 1 cm de côté au centre duquel sont regroupées les micropointes dans une région carrée de 1 mm de côté, et chaque patte 44 épouse la forme d'un cube de côté compris entre 1 mm et 10 mm.

En outre, l'aimant 46 est remplaçable par un électroaimant comportant un noyau de même forme que l'aimant 46 et disposé comme ce dernier, et une bobine entourant le noyau (sous ladite face libre 37 par exemple).

A cet électro-aimant peut être ajouté un autre électro-aimant identique, associé à deux autres pattes identiques aux pattes 44 mais respectivement situées contre les deux autres faces latérales opposées de la cathode émissive (qui peut alors avoir, en vue de dessus, la forme d'un carré) et en contact avec la couche ferromagnétique 8 (figure 5) tout en ne dépassant pas de la surface de celle-ci et en ayant des dimensions prévues pour ne pas dépasser des côtés de la cathode émissive contre lesquels elles se trouvent. En faisant varier les courants d'alimentation des électro-aimants, on peut ainsi faire varier en direction et/ou en sens et/ou en intensité le champ magnétique dans la couche 8. On peut par exemple réaliser un champ tournant parallèlement à cette couche, ce qui fait tourner le spin des électrons autour de la trajectoire de ceux-ci.

Sur la figure 6, on a représenté schématiquement un autre mode de réalisation particulier de la source objet de l'invention, dans lequel la cathode émissive 16 a une structure matricielle. Plus précisément, sur une plaque de verre 48 sont déposées une pluralité de bandes 50 conductrices et parallèles. Une couche isolante 52, par exemple en silice, recouvre ces bandes 50. Une pluralité d'autres bandes conductrices et parallèles 54, perpendiculaires aux bandes 50, sont déposées sur la couche isolante 52. Dans les zones 56 "d'intersection" des bandes 50 et 54, les bandes 54 et la couche 52 sont percées de trous et les bandes 50 sont pourvues de micropointes du genre des micropointes 10 à portion ferromagnétique 12 de la figure 1, qui reposent sur les bandes 50 et affleurent les bandes 54.

A titre purement indicatif et nullement limitatif, les bandes 50 ont une largeur de l'ordre de 0,1 mm à 1 mm, une épaisseur de l'ordre de 1 micromètre et sont espacées les unes des autres d'une distance de l'ordre de 10 micromètres à 0,1 mm.

De même, les bandes 54 ont une largeur de l'ordre de 0,1 mm à 1 mm, une épaisseur de l'ordre de 1 micromètre et sont espacées les unes des autres d'une distance de l'ordre de 10 micromètres à 0,1 mm.

On comprend qu'une polarisation appropriée des bandes 50 et 54 permette d'obtenir, lorsque la cathode émissive 16 est placée dans le vide, des faisceaux d'électrons pour des zones 56 déterminées. Par exemple la polarisation négative d'une bande 50 déterminée par rapport à une bande 54 déterminée permet d'obtenir, lorsque la cathode est dans le vide, un faisceau d'électrons émis par les micropointes de la zone 56 correspondant à l'intersection de ces bandes 50 et 54 déterminées.

En plaçant en outre la cathode dans un champ magnétique perpendiculaire au plan des couches 54, les électrons émis par la ou les zones 56 sélectionnées sont polarisés de spin, comme on l'a expliqué en référence aux figures 1 et 2 (du fait de l'utilisation de micropointes à portion ferromagnétique).

On peut aussi envisager d'entourer chaque zone 56 d'un conducteur 58 en forme de oméga majuscule, comme on l'a expliqué en référence à la figure 3. On forme ainsi un réseau de tels conducteurs 58 que l'on munit de lignes de connexion appropriées 60 (figure 7) de façon à pouvoir réaliser un adressage matriciel des conducteurs 58. Ces conducteurs 58 et les lignes 60 sont bien entendu placés dans une couche isolante 62 par exemple en silice, qui est déposée sur l'ensemble des bandes 54.

On peut ainsi créer un champ magnétique dans une zone 56 déterminée, ce champ étant perpendiculaire à la zone 56 considérée, de sorte que le faisceau d'électrons émis par cette zone 56 est polarisé de spin.

Des procédés de fabrication de cathodes émissives à micropointes, simples ou à structure matricielle, sont connus dans l'état de la technique.

On indique également ci-après un procédé permettant d'obtenir une cathode à structure matricielle. Ce procédé comprend les étapes successives suivantes :

- dépôt, par pulvérisation cathodique, d'une première couche conductrice d'oxyde d'indium, sur un substrat isolant (plaque de verre recouverte, par pulvérisation cathodique, de $SiO_2$),
- gravure de la première couche (à travers un masque de résine positive et par attaque chimique avec de l'acide orthophosphorique porté à 110°C, le masque étant ensuite éliminé par dissolution chimique), pour former des premières bandes conductrices parallèles,
- dépôt d'une seconde couche isolante de $SiO_2$ sur la structure obtenue (par une technique de dépôt chimique en phase vapeur à partir de silane, phosphine et oxygène),
- dépôt d'une troisième couche conductrice en niobium sur la seconde couche (par évaporation sous vide),
- ouvertures de trous débouchant dans les troisième et seconde couches, ces trous étant répartis sur l'ensemble de la surface des troisième et seconde couches et formés à travers un masque de résine approprié (obtenu par photolithographie) représentant l'image en positif des trous, par gravure ionique réactive, au moyen de $SF_6$, de la troisième couche, par attaque chimique, au moyen d'une solution de HF et de $NH_4F$, de la seconde couche, puis par élimination du masque,
- dépôt sur la troisième couche gravée, d'une quatrième couche ne recouvrant pas les trous (par évaporation sous vide de nickel, sous une incidence rasante de 15° par rapport à la surface de la structure),
- dépôt sur l'ensemble de la structure obtenue d'une cinquième couche d'un matériau émetteur d'électrons tel que le molybdène, sous incidence normale par rapport à la surface de la structure,
- élimination, par dissolution sélective par un procédé électrochimique, de la quatrième couche entraînant l'élimination du matériau émetteur d'électrons surmontant ladite quatrième couche et le maintien dudit matériau émetteur dans les trous,

- gravure (à travers un masque de résine approprié obtenu par photolithographie) des troisième et seconde couches pour mettre à nu une au moins des extrémités des premières bandes conductrices, ce qui permet des prises de contact électrique, et
- gravure de la troisième couche pour former des secondes bandes conductrices parallèles, les première et seconde bandes étant croisées, cette gravure étant une gravure ionique réactive, au moyen de $SF_6$, effectuée au travers d'un masque de résine obtenu par photolithographie, et éliminé par attaque chimique une fois la gravure terminé.

Pour former lesdites portions ferromagnétiques 12 utilisées dans la présente invention, on modifie le procédé indiqué de la façon suivante : le dépôt de ladite cinquième couche peut être effectué par évaporation sous vide d'un matériau approprié, évaporation dont on contrôle la durée. On peut ainsi interrompre cette évaporation lorsque une hauteur suffisante des micropointes (ayant alors une forme tronconique) est obtenue et poursuivre l'évaporation avec un matériau conducteur et ferromagnétique à température ambiante, de façon à obtenir les micropointes de forme conique, à portion ferromagnétique.

A titre d'exemple, ladite cinquième couche est obtenue par évaporation sous vide d'un matériau tel que le molybdène (ou le niobium), pendant une durée appropriée, de façon à obtenir des éléments de forme tronconique de hauteur voulue, et on effectue ensuite une évaporation sous vide d'un matériau tel que le fer (ou mieux un composé fernickel, par exemple $Fe_{0,2}-Ni_{0,8}$) pendant un temps déterminé, de façon à compléter les éléments pour obtenir des micropointes coniques.

Le mode de réalisation de l'invention dans lequel la couche 8 est en alliage samarium-cobalt est obtenu par le procédé indiqué, dans lequel ladite troisième couche est réalisée en alliage samarium-cobalt. Lorsque la cathode émissive correspondante est obtenue, on la chauffe sous vide tout en polarisant négativement les micropointes par rapport à cette couche 8, de façon à effectuer un traitement thermique de celle-ci permettant d'améliorer ses propriétés ferromagnétiques. En plaçant ensuite la cathode émissive 16 dans un champ magnétique parallèle à la couche d'alliage samarium-cobalt, on aimante celle-ci de façon permanente.

La réalisation décrite en référence à la figure 3 nécessite une étape complémentaire en vue de former la couche de silice 30. A cet effet, on dépose une couche de silicium sur la couche 8 à travers un masque approprié empêchant le dépôt de silicium à l'endroit des trous et on oxyde le silicium déposé. La couche d'aluminium 32 peut être déposée à travers un masque approprié.

La réalisation de la figure 4 nécessite de remplacer le dépôt de ladite troisième couche par un double dépôt, à savoir un premier dépôt d'une couche par exemple en molybdène, suivi d'un dépôt par exemple en fer.

La présente invention peut trouver des applications :

- dans les études de diffraction électronique, de photo-émission inverse, de spectroscopie AUGER..., en microscopie électronique (en faisant suivre la source d'électrons, d'optiques électrostatiques pour ne pas interférer avec le champ magnétique nécessaire à la source),
- dans l'étude des interactions d'électrons avec des particules sub-atomiques, des atomes, des molécules ou des ions et notamment en physique des plasmas, domaine dans lequel l'invention peut permettre d'ioniser des atomes ou des molécules et de porter ceux-ci dans des états électroniques excités d'un type particulier, en vue de favoriser ensuite une réaction chimique déterminée, ce qui est très difficile, voire impossible, à réaliser, avec les sources d'électrons polarisés de spin de l'art antérieur, qui ne permettent pas d'obtenir des faisceaux électroniques assez intenses pour cela,
- pour la lecture d'informations enregistrées dans un matériau ferromagnétique qui a la propriété d'absorber sélectivement un faisceau électronique polarisé de spin, la partie absorbée dépendant de l'intensité d'aimantation du matériau au point d'impact du faisceau,
- dans le domaine spatial, la source de l'invention étant réalisable avec un faible poids et un faible encombrement et utilisable dans le vide spatial.

## Revendications

1. Source d'électrons polarisés de spin, caractérisée en ce qu'elle comprend au moins une première électrode (4) dont une face est pourvue d'une pluralité de micropointes (10) qui sont faites d'un matériau émetteur d'électrons et dont les bases se trouvent sur ladite face, et au moins une seconde électrode (8), cette seconde électrode étant électriquement isolée de la première électrode, disposée en regard de ladite face et percée de trous (9) situés respectivement en regard des dites bases, le sommet de chaque micropointe étant situé au niveau du trou qui lui correspond, de sorte que des électrons sont émis par les micropointes (10) lorsque celles-ci sont dans le vide et que la seconde électrode (8) est polarisée positivement par rapport à la première électrode (4), et en ce qu'au moins une portion (12) de chaque micropointe, incluant le sommet de celle-ci, est ferromagnétique, de façon que les électrons émis soient polarisés de spin suivant une direction donnée, lorsque chaque portion (12) est soumise à un champ magnétique parallèle à ladite direction donnée.

2. Source selon la revendication 1, caractérisée en ce que chaque portion (12) est faite ou recouverte d'un matériau ferromagnétique à température ambiante.

3. Source selon la revendication 2, caractérisée en ce que ledit matériau est choisi dans le groupe comprenant le fer, le nickel et les alliages contenant du fer et du nickel.

4. Source selon l'une quelconque des revendications 2 et 3, caractérisée en ce que, les micropointes (10) étant orientées suivant un même axe, ladite source comprend en outre des moyens (18) pour soumettre chaque portion (12) un champ magnétique parallèle à cet axe.

5. Source selon l'une quelconque des revendications 1 à 4, caractérisée en ce qu'elle comprend plusieurs exemplaires (50) parallèles et de forme allongée de ladite première électrode et plusieurs exemplaires (54) parallèles et de forme allongée de ladite seconde électrode, en ce que les premières électrodes (50) font un angle avec les secondes électrodes (54), ce qui définit des zones de croisements (56) des premières et secondes électrodes, et en ce que les micropointes (10) et les trous (9) sont situés dans ces zones de croisement (56).

6. Source selon la revendication 5, caractérisée en ce que, les micropointes (10) étant orientées suivant un même axe, ladite source comprend en outre des moyens (58) pour soumettre individuellement chaque zone de croisement (56) à un champ magnétique parallèle à cet axe.

7. Source selon la revendication 2, caractérisée en ce que, les micropointes (10) étant orientées suivant un même axe, ladite seconde électrode (8) comporte une couche (42) plane, perpendiculaire audit même axe et faite d'un matériau ferromagnétique à température ambiante.

8. Source selon la revendication 7, caractérisée en ce que l'épaisseur de la couche plane (42) est au moins égale à la hauteur de ladite portion (12) de micropointe (10), comptée parallèlement audit axe et en ce que chaque portion de micropointe est comprise dans le trou qui lui correspond dans ladite couche plane (42).

9. Source selon l'une quelconque des revendications 7 et 8, caractérisée en ce qu'elle comprend en outre des moyens pour soumettre chaque portion de micropointe à un champ magnétique perpendiculaire à ladite couche plane.

10. Source selon l'une quelconque des revendications 7 et 8, caractérisée en ce qu'elle comprend en outre des moyens (44, 46) pour soumettre chaque portion (12) de micropointe (10) à un champ magnétique parallèle à ladite couche plane (42) et canalisé par cette couche plane (42).

11. Application de la source selon l'une quelconque des revendications 1 à 10, en physique des interactions électrons-matière ou électrons-particules, en physique des plasmas et en microscopie électronique.

**Claims**

1. Source of spin polarized electrons, characterized in that it comprises at least one first electrode (4), whereof one face is provided with a plurality of micropoints (10) made from an electron emitting material and whose bases are located on said face, and at least one second electrode (8), which is electrically insulated from the first electrode, positioned facing said face and having holes (9) respectively facing said bases, the top of each micropoint being positioned level with the hole corresponding thereto, so that electrons are emitted by micropoints (10) when the latter are in vacuum and the second electrode (8) is positively polarized with respect to the first electrode (4), and in that at least one portion (12) of each micropoint, including the top thereof, is ferromagnetic, so that the emitted electrons are spin polarized in a given direction, when each portion (12) is subject to a magnetic field parallel to said given direction.

2. Source according to claim 1, characterized in that each portion (12) is formed or covered by a material which is ferromagnetic at ambient temperature.

3. Source according to claim 2, characterized in that said material is chosen from the group including iron, nickel and alloys containing iron and nickel.

4. Source according to claims 2 and 3, characterized in that with the micropoints (10) oriented in accordance with the same axis, said source also comprises means (18) for subjecting portion (12) to a magnetic field parallel to said axis.

5. Source according to any one of the claims 1 to 4, characterized in that it comprises several parallel, elongated first electrodes (50) and several parallel, elongated second electrodes (54), in that the first electrodes (50) form an angle with the second electrodes (54) defining intersection zones (56) of the first and second electrodes and in that the micropoints (10) and holes (9) are located in said intersection zones (56).

6. Source according to claim 5, characterized in that with the micropoints (10) oriented in accordance with the same axis, said source also comprises means (58) for individually subjecting each intersection zone (56) to a magnetic field parallel to said axis.

7. Source according to claim 2, characterized in that with the micropoints (10) oriented in accordance with the same axis, said second electrode (8) has a planar layer (42) perpendicular to the same axis and made from a material which is ferromagnetic at ambient temperature.

8. Source according to claim 7, characterized in that the thickness of planar layer (42) is at least equal to the height of said portion (12) of micropoint (10), counted parallel to said axis and in that each micropoint portion is located in the hole corresponding thereto in planar layer (42).

9. Source according to either of the claims 7 and 8, characterized in that it also comprises means for subjecting each micropoint portion to a magnetic field perpendicular to said planar layer.

10. Source according to either of the claims 7 and 8, characterized in that it also comprises means (44, 46) for subjecting each portion (12) of micropoint (10) to a magnetic field parallel to the planar layer (42) and channel led by the latter.

11. Application of the source according to any one of the claims 1 to 10 to the physics of electron-matter or electron-particle interactions, to plasma physics and to electron microscopy.

**Patentansprüche**

1. Spinpolarisierte Elektronenquelle, **dadurch gekennzeichnet,** daß sie wenigstens eine erste Elektrode (4) enthält, deren eine Seite mit mehreren Mikrospitzen (10) versehen ist, die aus einem Elektronenemittermaterial bestehen und deren Basen sich in der genannten Fläche befinden, und wenigstens eine zweite Elektrode (8) enthält, die elektrisch von der ersten Elektrode isoliert ist und der genannten Fläche gegenübersteht und von Löchern (9) durchdrungen ist, die jeweils den genannten Basen gegenüberliegen, wobei der Gipfel jeder Mikrospitze in Höhe des ihm entsprechenden Lochs gelegen ist, so daß Elektronen von den Mikrospitzen (10) abgegeben werden, wenn diese im Vakuum sind und die zweite Elektrode (8) positiv gegenüber der ersten Elektrode (4) vorgespannt ist, und daß wenigstens ein Teil (12) einer jeden Mikrospitze einschließlich deren Gipfel ferromagnetisch ist, so daß die emittierten Elektronen in einer gegebenen Richtung spinpolarisiert sind, wenn jeder Abschnitt (12) einem magnetischen Feld unterworfen ist, das parallel zur genannten gegebenen Richtung ist.

2. Quelle nach Anspruch 1, **dadurch gekennzeichnet,** daß jeder Abschnitt (12) aus einem bei Umgebungstemperatur ferromagnetischen Material besteht oder davon bedeckt ist.

3. Quelle nach Anspruch 2, **dadurch gekennzeichnet,** daß das genannte Material aus der Gruppe ausgewählt ist, die Eisen, Nickel und Legierungen aus Eisen und Nickel enthält.

4. Quelle nach einem der Ansprüche 2 und 3, **dadurch gekennzeichnet,** daß bei gleichachsiger Ausrichtung der Mikrospitzen (10) die genannte Quelle weiterhin Einrichtungen (18) enthält, um jeden Abschnitt (12) einem zu dieser Achse parallelen magnetischen Feld zu unterwerfen.

5. Quelle nach einem der Ansprüche 1 bis 4, **dadurch gekennzeichnet,** daß sie mehrerer parallele Exemplare (50) von länglicher Form der ersten Elektrode und mehrere parallele Exemplare (54) von länglicher Gestalt der genannten zweiten Elektrode enthält, und daß die ersten Elektroden (50) einen Winkel mit den zweiten Elektroden (54) bilden, was Kreuzungszonen (56) der ersten und zweiten Elektroden ausbildet, und daß die Mikrospitzen (10) und die Löcher (9) in diesen Kreuzungszonen (56) gelegen sind.

6. Quelle nach Anspruch 5, **dadurch gekennzeichnet,** daß bei gleichachsiger Ausrichtung der Mikrospitzen (10) die genannte Quelle weiterhin Einrichtungen (58) enthält, um jede Kreuzungszone (56) individuell einem zu dieser Achse parallelen Magnetfeld auszusetzen.

7. Quelle nach Anspruch 2, **dadurch gekennzeichnet,** daß bei gleichachsiger Ausrichtung der Mikrospitzen (10) die genannte zweite Elektrode (2) eine ebene Schicht (42) senkrecht zu der genannten Achse und aus einem bei Umgebungstemperatur ferromagnetischen Material enthält.

8. Quelle nach Anspruch 7, **dadurch gekennzeichnet,** daß die Dicke der ebenen Schicht (42) wenigstens gleich der Höhe des genannten Abschnitts (12) der Mikrospitze (10) ist, gerechnet parallel zur genannten Achse, und daß jeder Mikrospitzenabschnitt sich in dem Loch befindet, das ihm in der genannten ebenen Schicht (42) entspricht.

9. Quelle nach einem der Ansprüche 7 und 8, **dadurch gekennzeichnet,** daß sie weiterhin Einrichtungen enthält, um jeden Mikrospitzenabschnitt einem zu der genannten ebenen Schicht senkrechten Magnetfeld auszusetzen.

10. Quelle nach einem der Ansprüche 7 und 8, **dadurch gekennzeichnet,** daß sie weiterhin Einrichtungen (44, 46) enthält, um jeden Abschnitt (12) der Mikrospitze (10) einem zu der genannten ebenen Schicht (42) parallelen Magnetfeld auszusetzen, das durch diese ebene Schicht (42) kanalisiert ist.

11. Anwendung der Quelle nach einem der Ansprüche 1 bis 10 bei der Physik der Wechselwirkungen zwischen Elektronen und Materie oder zwischen Elektronen und Partikeln und bei der Plasmaphysik und bei der Elektronenmikroskopie.

**FIG. 1**

**FIG. 2**

FIG. 3

FIG. 4

FIG. 5

FIG. 7

FIG. 6

58

60

58

56

58

62

16

50

50

54

52

50

48

EP 0 272 178 B1